# EUROPÄISCHE PATENTSCHRIFT

(11) **EP 2 514 056 B1**
(45) Veröffentlichungstag und Bekanntmachung des Hinweises auf die Patenterteilung: **03.08.2016**
(21) Anmeldenummer: 10790368.4
(22) Anmeldetag: 29.11.2010
(51) Int. Cl.: H02H 1/00, H02J 13/00, G06F 21/00

(54) **VERFAHREN ZUM PRÜFEN VON ELEKTRISCHEN KOMPONENTEN IN EINEM STROMNETZ, INSBESONDERE IN EINEM GEBÄUDESTROMNETZ**
METHOD FOR TESTING ELECTRIC COMPONENTS IN A MAINS SUPPLY, IN PARTICULAR IN A MAINS SUPPLY FOR A BUILDING
PROCÉDÉ POUR CONTRÔLER DES COMPOSANTS ÉLECTRIQUES DANS UN RÉSEAU ÉLECTRIQUE, EN PARTICULIER DANS UN RÉSEAU ÉLECTRIQUE D'UN BÂTIMENT

(30) Priorität: 18.12.2009 DE 102009058877
(43) Veröffentlichungstag der Anmeldung: 24.10.2012
(73) Patentinhaber: Siemens Aktiengesellschaft, 80333 München (DE)
(72) Erfinder: FALK, Rainer, 85435 Erding (DE); FRIES, Steffen, 85598 Baldham (DE); SVOBODA, Milos, 81549 München (DE)
(86) Internationale Anmeldenummer: PCT/EP2010/068380
(87) Internationale Veröffentlichungsnummer: WO 2011/073019

(56) Entgegenhaltungen:
- EP-A2- 1 005 133
- US-A- 5 495 406
- US-A1- 2002 101 695
- US-A1- 2004 193 329

## Beschreibung

Die Erfindung betrifft ein Verfahren zum Prüfen von elektrischen Komponenten in einem Stromnetz, insbesondere in einem Gebäudestromnetz, sowie eine entsprechende Prüfeinheit und eine entsprechende elektrische Komponente zur Verwendung in einem solchen Verfahren.

Aus dem Stand der Technik sind verschiedene Verfahren bekannt, wie technische Produkte geeignet identifiziert werden können, um diese Produkte von nachgebauten bzw. gefälschten Produkten zu unterscheiden. Beispielsweise kommen sog. RFID-Tags zum Einsatz, mit denen drahtlos Information zu einem technischen Produkt, insbesondere ein elektronischer Produktcode, ausgelesen werden können. Ferner ist es bekannt, Halbleiter-Chips in technischen Geräten zu verbauen, welche kryptographische Operationen ausführen können, um damit ein Originalprodukt zuverlässig erkennen zu können. Es ist weiterhin bekannt, an technischen Produkten oder Verpackungen Sicherheitsmerkmale durch Aufdrucken eines Codes bzw. verborgener Bilder aufzubringen. Die verborgenen Bilder können dabei nur mittels einer speziellen Decodierlinse sichtbar gemacht werden.

In Stromnetzen ist es aus Sicherheitsgründen besonders wichtig, dass die darin verbauten elektrischen Komponenten bestimmten Sicherheitsanforderungen genügen, um hierdurch Fehlfunktionen zu vermeiden, welche zur Beschädigung von elektrischen Verbrauchern im Stromnetz führen können bzw. unter Umständen auch eine Gefahr für menschliche Nutzer des Stromnetzes darstellen. Bestimmte Fehlfunktionen von elektrischen Komponenten in einem Stromnetz können gegebenenfalls mittelbar über die Detektion von im Stromnetz auftretenden Strömen bzw. Spannungen detektiert werden. Es ist jedoch nicht bekannt, wie auf einfache Weise direkt einzelne elektrische Komponenten in einem Stromnetz überprüft werden können.

In der Druckschrift US 5 495 406 A ist ein System zur Steuerung von Lasten in einem Stromnetz beschrieben, wobei Steuersignale von einer zentralen Steuereinheit über das Stromnetz an elektrische Komponenten gesendet werden. Ebenso können die elektrischen Komponenten über das Stromnetz Signale an die zentrale Steuereinheit übermitteln. Dabei werden Gateways verwendet, welche Signale aus dem Stromnetz in entsprechende Signale einer Signalübertragungsleitung übersetzen, an welche die zentrale Steuereinheit angebunden ist. Ebenso übernehmen die Gateways die Funktion der Übersetzung von Signalen auf der Signalübertragungsleitung in Signale, die über das Stromnetz übertragen werden.

In dem Dokument EP 1 005 133 A2 wird die Ansteuerung eines Unterbrechers in einem Stromnetz über ein Kommunikationssignal auf einer Stromleitung beschrieben.

Die Druckschrift US 2004/0193329 A1 offenbart ein Stromverteilsystem, bei dem über eine Vielzahl von IED-Geräten Informationen aus dem Stromnetz erfasst werden, welche an ein Kommunikationsnetz übertragen werden. Im Rahmen der Datenübertragung im Kommunikationsnetz wird die Authentisierung von IED-Geräten beschrieben.

Aufgabe der Erfindung ist es, eine einfache Prüfung von elektrischen Komponenten in einem Stromnetz zu ermöglichen.

Diese Aufgabe wird durch das Verfahren gemäß Patentanspruch 1 bzw. die Prüfeinheit gemäß Patentanspruch 14 bzw. die elektrische Komponente gemäß Patentanspruch 17 gelöst. Weiterbildungen der Erfindung sind in den abhängigen Ansprüchen definiert.

Das erfindungsgemäße Verfahren ermöglicht die Prüfung von elektrischen Komponenten in einem Stromnetz und kann insbesondere in einem lokalen Gebäudestromnetz, wie z.B. dem Stromnetz eines Haushalts bzw. einer Mehrzahl von Haushalten verwendet werden. Erfindungsgemäß wird von einer Prüfeinheit ein Prüfkommando mittels einer Datenübertragung über das Stromnetz an eine oder mehrere elektrische Komponenten des Stromnetzes gesendet. Anschließend sendet eine jeweilige elektrische Komponente, welche das an sie gerichtete Prüfkommando empfängt, eine die jeweilige elektrische Komponente charakterisierende Prüfantwort mittels einer Datenübertragung über das Stromnetz an die Prüfeinheit zurück, woraufhin die zurückgesendete Prüfantwort in der Prüfeinheit ausgewertet wird. Das erfindungsgemäße Verfahren kann dabei zur Überprüfung von beliebigen, in einem Stromnetz verbauten elektrischen Komponenten verwendet werden. Vorzugsweise wird das Verfahren zur Überprüfung von Sicherungen und/oder Fehlerstrom-Schutzschaltern im Stromnetz verwendet, da diese Komponenten Sicherheitsfunktionen erfüllen, so dass eine Fehlfunktion dieser Komponenten unter Umständen schwerwiegende Konsequenzen haben kann.

Im erfindungsgemäßen Verfahren umfasst die Auswertung der Prüfantwort eine Authentisierung der die Prüfantwort zurücksendenden elektrischen Komponente. Bei dieser Authentisierung wird über das von der Prüfeinheit ausgesendete Prüfkommando und die von der elektrischen Komponente zurückgesendete Prüfantwort die elektrische Komponente in der Prüfeinheit authentisiert. Es können dabei beliebige, aus dem Stand der Technik bekannte Authentisierungsverfahren zum Einsatz kommen. Die Erfindung hat den Vorteil, dass auf einfache Weise Nachbauten bzw. Plagiate von elektrischen Komponenten im Stromnetz erkannt werden können.

Der Erfindung liegt die Idee zu Grunde, dass eine Datenübertragung über ein Stromnetz dazu genutzt werden kann, um elektrische Komponenten in dem Stromnetz basierend auf Prüfkommandos bzw. Prüfantworten zu identifizieren. Es müssen somit keine separaten Übertragungskanäle geschaffen werden, um einen Kommunikationsaustausch zwischen einer Prüfeinheit und den zu prüfenden elektrischen Komponenten zu ermöglichen. Auf diese Weise kann das erfindungsgemäße Verfahren auf einfache Weise realisiert werden.

Basierend auf einer geeigneten Auswertung der Prüfantworten können mit dem erfindungsgemäßen Verfahren z.B. fehlerhafte Installationen des Stromnetzes bzw. die Verwendung fehlerhafter Komponenten im Stromnetz und hierdurch potentielle Probleme frühzeitig erkannt werden. Auch schwer zugängliche bzw. unzugängliche elektrische Komponenten können einfach überprüft werden. Somit kann Beschädigungen von elektrischen Leitungen, elektrischen Geräten bis hin zu Bränden sowie Verletzungen von menschlichen Nutzern (z.B. durch Stromschläge) vorgebeugt werden. Ferner können Nachbauten von elektrischen Komponenten, Komponenten ohne erforderliches Prüfsiegel oder die Verwendung von falschen Komponenten (unterdimensioniert, falscher Spannungsbereich, für den Einsatz in Industrieumgebung nicht vorgesehen) erkannt werden. Abweichungen einer Elektroinstallation von entsprechenden Normen können gegebenenfalls automatisiert detektiert werden, z.B. wenn in der Installation ein entsprechender Fehlerstrom-Schutzschalter fehlt bzw. wenn eine Sicherung in dem Stromnetz für einen falschen Nennstrom spezifiziert ist.

In einer besonders bevorzugten Ausführungsform wird eine Authentisierung einer elektrischen Komponente derart durchgeführt, dass das Prüfkommando Verifizierungsdaten enthält, welche von der jeweiligen elektrischen Komponente, die das an sie gerichtete Prüfkommando empfängt, kryptographisch gesichert (z.B. verschlüsselt) werden, wobei die kryptographisch gesicherten Verifizierungsdaten innerhalb der Prüfantwort zurückgesendet werden und in der Prüfeinheit die jeweilige elektrische Komponente erfolgreich authentisiert wird, falls die kryptographisch gesicherten Verifizierungsdaten in der Prüfeinheit verifizierbar (z.B. entschlüsselbar) sind. Diese Variante der Erfindung beruht auf dem Prinzip des aus dem Stand der Technik bekannten Challenge-Response-Verfahrens. Die Verifizierungsdaten umfassen dabei vorzugsweise eine entsprechende Pseudo-Zufallszahl, welche von der Prüfeinheit generiert wird. Der Begriff der kryptographischen Sicherung ist hier und im Folgenden weit auszulegen. In speziellen Ausführungsformen umfasst die kryptographische Sicherung ein Verschlüsseln der Verifizierungsdaten und/oder das digitale Signieren der Verifizierungsdaten und/oder das Bilden einer kryptographischen Prüfsumme (z.B. eines Message Authentication Codes) basierend auf den Verifizierungsdaten.

In einer weiteren Variante des erfindungsgemäßen Verfahrens erfolgt die Authentisierung einer elektrischen Komponente über einen einzelnen symmetrischen Schlüssel. Dabei werden die Verifizierungsdaten in der jeweiligen elektrischen Komponente mit einem symmetrischen, in der jeweiligen elektrischen Komponente hinterlegten Schlüssel kryptographisch gesichert (z.B. verschlüsselt), wobei zum Verifizieren (z.B. Entschlüsseln) der kryptographisch gesicherten Verifizierungsdaten der symmetrische Schlüssel auch in der Prüfeinheit hinterlegt ist oder aus einem in der Prüfeinheit hinterlegten Master-Schlüssel mit in der Prüfantwort enthaltenen Identifikationsdaten der elektrischen Komponente abgeleitet wird. Als Kryptoalgorithmus kann z.B. ein AES-Algorithmus oder ein SHA-1 oder SHA-256-Algorithmus verwendet werden. Alternativ oder zusätzlich kann die Authentisierung auch basierend auf einem asymmetrischen Authentisierungsverfahren erfolgen. In diesem Fall werden die Verifizierungsdaten von der jeweiligen elektrischen Komponente mit einem privaten, in der jeweiligen elektrischen Komponente hinterlegten Schlüssel kryptographisch gesichert (z.B. verschlüsselt), wobei zum Verifizieren (z.B. Entschlüsseln) der kryptographisch gesicherten Verifizierungsdaten ein in der Prüfantwort enthaltener öffentlicher Schlüssel verwendet wird, falls ein in der Prüfantwort enthaltenes Zertifikat durch die Prüfeinheit erfolgreich verifiziert (z.B. entschlüsselt) wird. Ebenso besteht die Möglichkeit, dass zum Verifizieren der kryptographisch gesicherten Verifizierungsdaten ein öffentlicher Schlüssel verwendet wird, der bereits vorab in der Prüfeinheit hinterlegt ist. Als Kryptoalgorithmus kann z.B. ein RSA-Algorithmus oder ein auf elliptischen Kurven basierender Algorithmus, wie z.B. eine Multiplikation mit einem Schlüsselparameter oder EC-DAS, verwendet werden.

Die Prüfantwort, welche die jeweilige elektrische Komponente charakterisiert, kann beliebig ausgestaltet sein. In einer Variante kann die Prüfantwort als charakterisierende Daten nur die oben beschriebenen kryptographisch gesicherten Verifizierungsdaten enthalten, wobei durch die kryptographische Sicherung die entsprechende elektrische Komponente charakterisiert ist. Alternativ oder zusätzlich umfasst die Prüfantwort jedoch eine oder mehrere Informationen zu der Identität und/oder zu charakteristischen Eigenschaften der jeweiligen elektrischen Komponente, wie z.B. einen Identifikationscode bzw. eine eindeutige Seriennummer der jeweiligen elektrischen Komponente oder technische Eigenschaften der elektrischen Komponente, vorzugsweise den Betrieb der elektrischen Komponente charakterisierende Größen. Hierzu gehören beispielsweise zugelassene Nennspannungen bzw. Spannungsbereiche, Nennströme, Auslösecharakteristika, Leistungsaufnahmen und dergleichen.

In einer weiteren Ausführungsform des erfindungsgemäßen Verfahrens wird das Prüfkommando von der Prüfeinheit an eine oder mehrere vorbestimmte elektrische Komponenten im Stromnetz ausgesendet, d.h. in dem Prüfkommando wird auch eine elektrische Komponente bzw. eine Gruppe von elektrischen Komponenten spezifiziert, für welche das Prüfkommando gültig ist. Gegebenenfalls besteht auch die Möglichkeit, dass das Prüfkommando als Broadcast-Kommando in das Stromnetz ausgesendet wird, woraufhin jede elektrische Komponente, die dieses Kommando empfängt, mit einer entsprechenden Prüfantwort auf das Prüfkommando antwortet.

Wie bereits oben erwähnt, wird in dem erfindungsgemäßen Verfahren zur Übermittlung von Prüfkommandos und Prüfantworten eine Datenübertragung über das Stromnetz verwendet. Diese Datenübertragung kann beispielsweise auf der hinlänglich aus dem Stand der Technik bekannten PLC-Kommunikation beruhen (PLC = Power Line Communication). Basierend auf diesem Verfahren, welches durch unterschiedliche Normen spezifiziert wird, erfolgt die Übermittlung von Informationen im Stromnetz mittels hochfrequenter Signale, welche auf die niederfrequente Spannungskurve im Stromnetz (üblicherweise 50 Hz oder 60 Hz) aufmoduliert werden.

Gegebenenfalls kann das Prüfkommando und die Prüfantwort auch basierend auf einer Datenübertragung mittels einer Lastmodulation übermittelt werden. Bei der Lastmodulation werden Informationen durch das Aufschalten und/oder Verändern von einem oder mehreren elektrischen Lasten in dem Stromnetz übertragen. Hierdurch wird eine Veränderung in der Strom- bzw. Spannungskurve bewirkt, welche in der Prüfeinheit gemessen werden kann. Basierend auf der Messung kann dann eine entsprechende Information abgeleitet werden.

In einer weiteren Variante des erfindungsgemäßen Verfahrens werden das Prüfkommando und die Prüfantwort basierend auf einer Datenübertragung mittels einer Phasenanschnitt- und/oder Phasenabschnittsteuerung übermittelt. Diese Steuerung ist an sich aus dem Stand der Technik bekannt. Eine Wechselspannung wird dabei verzögert nach dem Nulldurchgang mittels elektrischer Bauelemente wie z.B. Thyristoren eingeschaltet. Eine geeignete Verzögerung des Einschaltvorgangs des Stroms wird in dieser Variante nunmehr auch dazu genutzt, um hiermit Informationen im Stromnetz zu codieren.

In einer weiteren Ausgestaltung des erfindungsgemäßen Verfahrens werden das Prüfkommando und die Prüfantwort basierend auf einer Datenübertragung mittels eines Trägersignals übermittelt, welches mit hinlänglich aus dem Stand der Technik bekannten Modulationsverfahren in der Form einer Frequenzumtastung (englisch: FSK = Frequency Shift Keying) und/oder einer Phasenumtastung (englisch: PSK = Phase Shift Keying) und/oder einer Pulsweitenmodulation moduliert ist.

Die Auswertung der zurückgesendeten Prüfantworten kann erfindungsgemäß auf verschiedene Art und Weise erfolgen. In einer bevorzugten Ausführungsform werden bei der Auswertung eine oder mehrere der elektrischen Komponenten des Stromnetzes im Hinblick auf die Erfüllung von einem oder mehreren Kriterien überprüft, wobei in Abhängigkeit von dem Überprüfungsergebnis eine oder mehrere Aktionen von der Prüfeinheit durchgeführt werden. Das oder die Aktionen können z.B. eine oder mehrere der folgenden Aktionen umfassen, wobei diese Aktionen insbesondere bei Nicht-Erfüllung und/oder nicht ausreichender Erfüllung eines oder mehrerer der Kriterien durchgeführt werden:
- Veränderung der Einstellung von einer oder mehreren der elektrischen Komponenten, sofern Einstellungsparameter der elektrischen Komponenten in geeigneter Weise angepasst werden können;
- Trennen des Stromnetzes von einer Netzversorgung oder Verhindern des Verbindens des Stromnetzes mit einer Netzversorgung;
- Übermitteln von Daten bezüglich der Konfiguration des Stromnetzes an eine Leitstelle;
- Ausgeben einer von einem Benutzer wahrnehmbaren Meldung, wobei diese Meldung z.B. als Warnmeldung bei der Erkennung von im Stromnetz nicht zulässiger bzw. falsch verbauter Komponenten und/oder bei der Detektion von fehlerhaften elektrischen Komponenten ausgegeben werden kann.

Das erfindungsgemäße Verfahren ist dabei nicht auf eine bestimmte Art der Auswertung beschränkt. Vielmehr kann die Auswertung in geeigneter Weise abhängig von der gewünschten Prüfung bzw. der zu prüfenden elektrischen Komponenten ausgestaltet sein.

Neben dem oben beschriebenen Verfahren umfasst die Erfindung ferner eine Prüfeinheit zur Verwendung in einem solchen Verfahren. Dabei ist die Prüfeinheit derart ausgestaltet, dass sie im Betrieb ein Prüfkommando mittels einer Datenübertragung über ein Stromnetz an eine oder mehrere elektrische Komponenten des Stromnetzes sendet. Ferner wertet die Prüfeinheit eine Prüfantwort aus, welche mittels einer Datenübertragung über das Stromnetz an die Prüfeinheit von einer jeweiligen elektrischen Komponente zurückgesendet wird und welche die jeweilige elektrische Komponente charakterisiert. Die Auswertung der Prüfeinheit umfasst dabei eine Authentisierung der die Prüfantwort zurücksendenden elektrischen Komponente. Bei dieser Authentisierung wird über das von der Prüfeinheit ausgesendete Prüfkommando und die von der elektrischen Komponente zurückgesendete Prüfantwort die elektrische Komponente in der Prüfeinheit authentisiert. Mit der Prüfeinheit kann gegebenenfalls jede Variante des oben beschriebenen erfindungsgemäßen Verfahrens realisiert sein. Das heißt, jedes der oben im Bezug auf das Prüfungsverfahren beschriebenen Merkmale, das die Ausgestaltung der Prüfeinheit betrifft, kann gegebenenfalls auch in der Prüfeinheit realisiert sein.

Die Prüfeinheit kann dabei eine portable Prüfeinheit sein, welche insbesondere mit dem Stromnetz über eine Steckdose verbindbar ist. Alternativ oder zusätzlich besteht jedoch auch die Möglichkeit, dass die Prüfeinheit eine fest in dem Stromnetz verbaubare Komponente ist, welche insbesondere in einem Stromzähler und/oder in einem Stromverteiler einbaubar ist.

Die Erfindung umfasst darüber hinaus eine elektrische Komponente zur Verwendung in dem oben beschriebenen erfindungsgemäßen Verfahren, wobei die elektrische Komponente derart ausgestaltet ist, dass sie bei Betrieb in einem Stromnetz bei Empfang eines Prüfkommandos einer Prüfeinheit eine Prüfantwort mittels einer Datenübertragung über das Stromnetz an die Prüfeinheit zurücksendet, wobei die Prüfantwort die elektrische Komponente charakterisiert und von der Prüfeinheit ausdurch die elektrische Komponente realisiert werden. Das heißt, die elektrische Komponente kann gegebenenfalls jedes der oben in Bezug auf das Prüfungsverfahren beschriebenen Merkmale der Erfindung beinhalten, sofern das entsprechende Merkmal die elektrische Komponente betrifft.

Ausführungsbeispiele der Erfindung werden nachfolgend anhand der beigefügten Figuren detailliert beschrieben.

Es zeigen:
- Fig. 1: eine schematische Darstellung einer ersten Ausführungsform der Erfindung;
- Fig. 2: eine schematische Darstellung einer zweiten Ausführungsform der Erfindung; und
- Fig. 3: ein Ablaufdiagramm, welches die in einer Variante des erfindungsgemäßen Verfahrens ausgetauschten Nachrichten zwischen einer Prüfeinheit und einer elektrischen Komponente verdeutlicht.

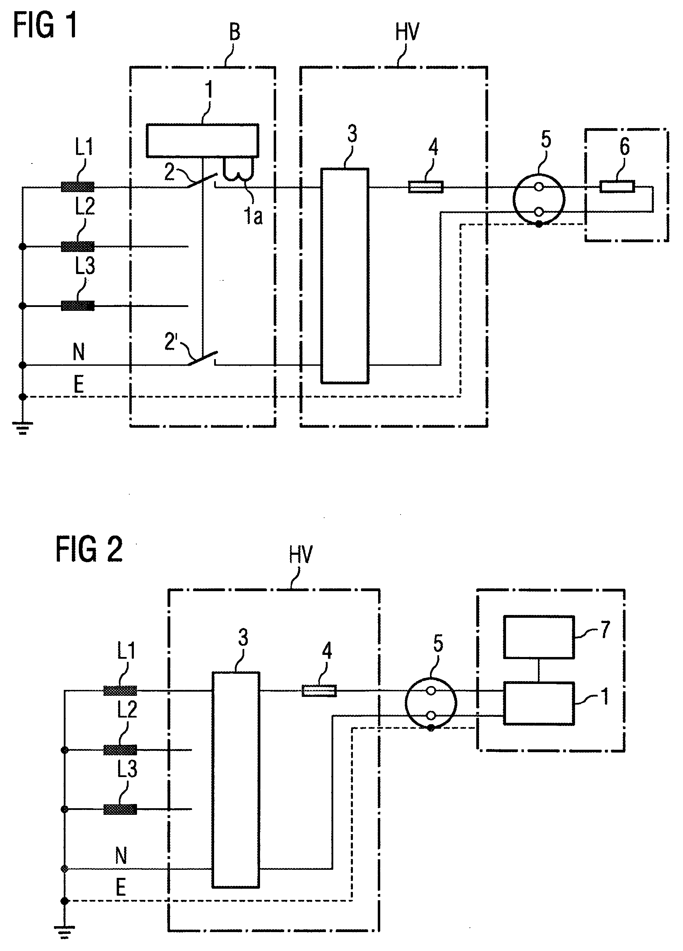

Fig. 1 zeigt eine erste Ausführungsform des erfindungsgemäßen Verfahrens zum Prüfen von elektrischen Komponenten am Beispiel eines Stromnetzes in einem Haushalt. Gemäß Fig. 1 wird elektrischer Wechselstrom basierend auf einer Drehspannung von 230 V über entsprechende Leitungen L1, L2 und L3 einem Stromnetz eines Haushalts zugeführt. Jede der Leitungen L1 bis L3 stellt dabei eine Phase des Wechselstroms dar. Ferner ist in Fig. 1 ein Nullleiter N sowie mit einer gestrichelten Linie die Erdungsleitung E angedeutet. Gemäß der Darstellung der Fig. 1 wird beispielhaft die Prüfung von mit der Leitung L1 verbundenen elektrischen Komponenten wiedergegeben. Der Strom auf der Leitung L1 gelangt zu einer Hauptverteilung HV, von der beispielhaft als Bestandteile ein entsprechender Fehlerstrom-Schutzschalter 3 (auch als FI-Schalter bezeichnet) und eine Sicherung 4 (z.B. 16A) dargestellt sind. Diese Komponenten führen zu einer entsprechenden Schutzkontaktsteckdose 5 im Haushalt, welche einen Verbraucher 6 mit Strom versorgt. Die Hauptverteilung HV umfasst dabei in der Regel mehr Komponenten, welche basierend auf dem erfindungsgemäßen Verfahren geprüft werden können. Im Folgenden wird nur die Prüfung des FI-Schalters 3 und der Sicherung 4 beispielhaft beschrieben.

Zur Prüfung der Komponenten 3 und 4 ist eine Prüfeinheit 1 vorgesehen, welche innerhalb einer Box B angedeutet ist und sowohl einen Teil der Hauptverteilung HV bilden kann als auch dieser geeignet vorgeschaltet sein kann. Über die Prüfeinheit 1 sind entsprechende Schalter 2 und 2' betätigbar, mit denen bei bestimmten Gegebenheiten die Stromversorgung hin zur Steckdose 5 und zum Verbraucher 6 unterbrochen werden kann, wie im Folgenden noch näher beschrieben wird.

Die Prüfeinheit 1 erzeugt zur Prüfung der elektrischen Komponenten 3 bzw. 4 entsprechende Prüfkommandos, welche erfindungsgemäß über das Stromnetz an den FI-Schalter 3 bzw. die Sicherung 4 übermittelt werden. Zur Informationsübermittlung über die Leitungen des Stromnetzes können dabei beliebige, aus dem Stand der Technik bekannte Verfahren eingesetzt werden. Insbesondere können die Daten mittels eines PLC-Verfahrens übertragen werden, bei dem auf die Stromleitung ein moduliertes Hochfrequenz-Signal gegeben wird. Hierfür ist eine schematisch angedeutete Koppelvorrichtung 1a vorgesehen, die ein moduliertes Trägersignal in das Stromnetz ein- bzw. auskoppelt. Das Prüfkommando kann dabei derart ausgestaltet sein, dass es eine bestimmte elektrische Komponente anspricht, welche daraufhin mit einer entsprechenden Prüfantwort antwortet. Es ist jedoch auch möglich, dass das Prüfkommando als Broadcast an das Stromnetz gesendet wird, woraufhin alle elektrischen Komponenten, welche das Prüfkommando empfangen, eine entsprechende Prüfantwort zurücksenden. Neben dem oben erwähnten PLC-Verfahren kann zur Datenübertragung über das Stromnetz beispielsweise auch eine Lastmodulation eingesetzt werden, bei der über eine in das Stromnetz schaltbare Last bzw. eine Last mit variierendem ohmschen Widerstand Informationen übermittelt werden, wobei diese Informationen durch eine Messung der Veränderung des Stroms aufgrund der sich verändernden Last in der Prüfeinheit 1 detektiert werden. Ebenso können zur Datenübertragung auch die anderen eingangs erwähnten Verfahren eingesetzt werden, insbesondere die Phasenanschnitt- bzw. Phasenabschnittsteuerung, eine Datenübermittlung basierend auf Frequenzumtastung und/oder Phasenumtastung und/oder Pulsweitenmodulation und dergleichen.

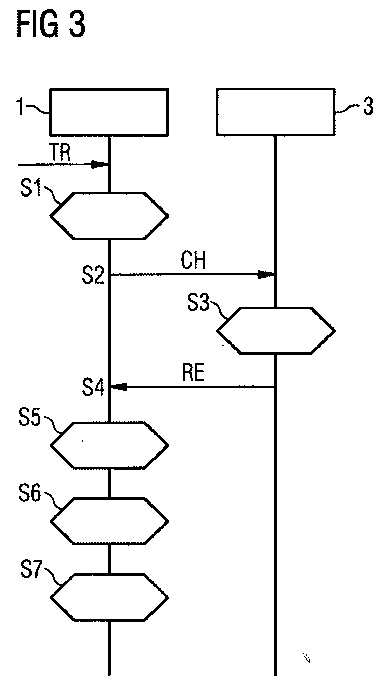

Basierend auf dem Prüfkommando und der Prüfantwort wird in der hier beschriebenen Ausführungsform eine Authentisierung der elektrischen Komponente mit Hilfe entsprechender Schlüssel unter Verwendung eines Challenge-Response-Verfahrens durchgeführt, wie weiter unten noch in Bezug auf Fig. 3 erläutert wird. Die im Rahmen dieses Verfahrens generierte Prüfantwort wird wiederum basierend auf einer geeigneten Datenübertragung über das Stromnetz, wie z.B. PLC, an die Prüfeinheit 1 zurückgesendet. Die Prüfantwort enthält dabei charakteristische Informationen bezüglich der die Prüfantwort zurücksendenden elektrischen Komponente, beispielsweise den Hersteller der elektrischen Komponente und/oder das Modell der elektrischen Komponente und/oder eine eindeutige Seriennummer der elektrischen Komponente und/oder Informationen hinsichtlich der Zulassung der elektrischen Komponente und/oder charakteristische Eigenschaften der elektrischen Komponente, wie z.B. Netzspannung/zugelassener Spannungsbereich, den Nennstrom einer Sicherung (Bemessungsstrom), die Auslösecharakteristik, das Bemessungsschaltvermögen, die maximale Leitungsaufnahme, die Stromaufnahme beim Einschaltvorgang, die Fehlerstromabsicherung, das Erfordernis einer unterbrechungsfreien Stromversorgung oder einer Fehlerstromabsicherung für die geprüfte elektrische Komponente, und dergleichen. Entscheidend ist dabei, dass Informationen, welche für die entsprechende elektrische Komponente spezifisch sind bzw. diese charakterisieren, übermittelt werden. Gegebenenfalls können diese Informationen auch nur Authentisierungsinformationen umfassen, um in der Prüfeinheit 1 lediglich zu überprüfen, ob es sich um eine verbaute Originalkomponente des Herstellers oder um ein Plagiat handelt.

Basierend auf den Informationen in den empfangenen Prüfantworten entscheidet dann die Prüfeinheit 1, ob gegebenenfalls Schutzmechanismen für das Stromnetz ausgelöst werden. Diese Entscheidung kann z.B. auf einer in der Prüfeinheit hinterlegten Soll-Konfiguration des Stromnetzes des Haushalts getroffen werden, wobei bei größeren Abweichungen der aktuell über die Prüfantworten ermittelten Konfiguration von der Soll-Konfiguration entsprechende Maßnahmen getroffen werden, um einen sicheren Betrieb des Stromnetzes weiterhin zu gewährleisten. Beispielsweise können in Abhängigkeit von den Informationen in der Prüfantwort als Schutzmechanismen das Herabsetzen der insgesamt abgesicherten Last, das Herabsetzen der Empfindlichkeit des geprüften FI-Schutzschalters und dergleichen eingeleitet werden. Diese Mechanismen setzen eine Unterstützung der jeweiligen Funktionalität durch die entsprechenden elektrischen Komponenten voraus. Beispielsweise können durch die Prüfeinheit geprüfte Sicherungen als "Software-Sicherungen" ausgestaltet sein, bei denen der Grenzwert für den maximalen Strom nicht fest vorbelegt sein muss, sondern in geeigneter Weise an die angeschlossenen Verbraucher und damit an eine maximale Last angepasst sein kann. Eine weitere Schutzmaßnahme kann insbesondere auch das Öffnen der in Fig. 1 gezeigten Schalter 2 bzw. 2' sein, sofern gemäß bestimmten Kriterien keine ausreichende Sicherheit mehr im Stromnetz gewährleistet ist, z.B. weil Plagiate als elektrische Komponenten im Stromnetz verwendet werden. Ebenso besteht die Möglichkeit, dass im Falle, dass die Prüfung der elektrischen Komponenten bei geöffneten Schaltern 2 und 2' erfolgt, das Anschalten des Verbraucherkreises über die Schalter 2 und 2' nur dann zugelassen wird, wenn ein Prüfkriterium der angeschlossenen Verbraucher, welche ebenfalls durch die Prüfeinheit geprüft werden können, erfüllt ist, wie z.B. eine korrekte Nennspannung, eine maximale Gesamtlast und dergleichen.

In einer weiteren Variante des erfindungsgemäßen Verfahrens können basierend auf den in einer Prüfeinheit empfangenen Prüfantworten unterschiedliche Verbraucherkreise in einem Verteilerschrank abhängig von den Eigenschaften der angeschlossenen Geräte auf unterschiedlichen Versorgungsleitungen geschaltet werden. In einer weiteren Variante besteht beispielsweise die Möglichkeit, dass die Prüfeinheit über einen Anschluss eine Kommunikationsverbindung zu einer Leitstelle herstellt, um Informationen über die geprüften Komponenten an die Leitstelle zu übermitteln. Die Informationen können dabei gegebenenfalls wiederum über ein Stromnetz, z.B. basierend auf dem PLC-Verfahren, übertragen werden. Wird die Prüfeinheit beispielsweise innerhalb eines Stromzählers im Haushalt integriert, ist oftmals bereits ein entsprechender PLC-Anschluss zum Auslesen der Zählerdaten vorhanden, der dann auch dazu genutzt werden kann, um basierend auf den empfangenen Prüfantworten entsprechende Informationen zu den geprüften elektrischen Komponenten an eine Leitstelle zu übermitteln. Insbesondere wird dabei eine Meldung an die Leitstelle gegeben, wenn die Prüfeinheit feststellt, dass neue elektrische Komponenten in den Stromkreis fix eingebracht wurden, welche sich nicht geeignet authentisieren können. Dies ermöglicht das Feststellen von Veränderungen an einer Installation.

Die in Fig. 1 gezeigte Prüfeinheit ist fest in dem Stromnetz eines Haushalts integriert, beispielsweise innerhalb der Hauptverteilung bzw. als Teil eines Stromzählers. Es besteht jedoch gegebenenfalls auch die Möglichkeit, die Stromeinheit als separates und insbesondere portables Gerät auszugestalten, um im Bedarfsfall eine Überprüfung der entsprechenden Elektroinstallation in einem Haushalts-Stromnetz durchzuführen. Ein solches Ausführungsbeispiel ist in Fig. 2 verdeutlicht.

Die Ausführungsform der Fig. 2 entspricht dabei größtenteils der Ausführungsform der Fig. 1, so dass für gleiche Bauteile die gleichen Bezugszeichen verwendet werden. In Fig. 2 ist wiederum ein Teil des Haushalts-Stromnetzes wiedergegeben, dem über die Hauptverteilung HV Strom über entsprechende Leitungen L1 bis L3 zugeführt wird. Beispielhaft wird dabei wiederum die Prüfung eines FI-Schalters 3 sowie eine Sicherung 4 innerhalb der Hauptverteilung HV beschrieben, wobei diese Komponenten zu einer Schutzkontaktsteckdose 5 führen. Im Unterschied zur Ausführungsform der Fig. 1 ist die Prüfeinheit 1 im Stromnetz nicht fest installiert, sondern es handelt sich um eine portable Prüfeinheit, welche an die Steckdose 5 angeschlossen wird. Analog zur Prüfeinheit der Fig. 1 erfolgt in der portablen Prüfeinheit eine Prüfung der elektrischen Komponenten in der Form des FI-Schalters 3 und der Sicherung 4. Das Ergebnis der Prüfung bzw. ein entsprechender Warnhinweis wird nunmehr auf einem Display D angezeigt, welches mit der Prüfeinheit 1 verbunden ist bzw. Teil dieser Einheit bildet. Analog zur Prüfeinheit der Fig. 1 erfolgt dabei die Übertragung der Prüfkommandos bzw. Prüfantworten bezüglich hin bzw. weg von den Komponenten 3 bzw. 4 über das Stromnetz.

Fig. 3 zeigt zur Verdeutlichung des erfindungsgemäßen Verfahrens beispielhaft den Ablauf der Prüfung des FI-Schutzschalters 3 durch die Prüfeinheit 1. Die von der Prüfeinheit 1 durchgeführten Schritte sind dabei entlang der linken vertikalen Linie und die von dem FI-Schutzschalter 3 durchgeführten Schritte entlang der rechten vertikalen Linie wiedergegeben. Das Verfahren startet basierend auf einem Auslösesignal TR, welches z.B. in periodischen Abständen generiert wird. Ebenso kann das Auslösesignal z.B. durch eine Benutzereingabe an der Prüfeinheit generiert werden. In einem ersten Schritt S1 wird zunächst von der Prüfeinheit ein Prüfkommando in der Form einer sog. Challenge CH erzeugt, welche eine von der Prüfeinheit 1 generierte Pseudo-Zufallszahl umfasst. Diese Zufallszahl wird in Schritt S2 mit einem geeigneten, oben beschriebenen Verfahren über das Stromnetz an den Schutzschalter 3 übermittelt. Der Schutzschalter beinhaltet dabei einen geeigneten Chip zur Durchführung von kryptographischen Funktionen.

In Schritt S3 wird dann mit Hilfe des Chips basierend auf einem geheimen, privaten kryptographischen Schlüssel die Zufallszahl verschlüsselt und in eine Prüfantwort in der Form einer Response RE integriert. Diese Response wird in Schritt S4 an die Prüfeinheit 1 zurück übermittelt, wobei die Datenübermittlung wiederum über das Stromnetz mit einem geeigneten Verfahren erfolgt. Die Response RE beinhaltet neben der verschlüsselten Zufallszahl ferner weitere, gerätespezifische Informationen des Schutzschalters 3, wobei in der hier beschriebenen Ausführungsform zumindest ein Produkt-Identifikationscode enthalten ist. Darüber hinaus enthält die Response RE ein digital signiertes Zertifikat einer Zertifizierungsstelle, wobei innerhalb des Zertifikats ein öffentlicher Schlüssel enthalten ist.

Nach Empfang der Response RE in der Prüfeinheit 1 wird in Schritt S5 ein Authentisierungsvorgang durchgeführt, wobei zunächst die Antwort RE auf ihre Gültigkeit verifiziert wird. Dies erfolgt dadurch, dass die Echtheit des in der Antwort enthaltenen Zertifikats mittels einer Prüfung seiner digitalen Signatur überprüft wird, wobei hierzu in der Prüfeinheit 1 hinterlegte Informationen von der entsprechenden Zertifizierungsstelle verwendet werden bzw. online über eine geeignete Datenverbindung Informationen von der Zertifizierungsstelle abgefragt werden. Erweist sich das Zertifikat als gültig, wird versucht, die verschlüsselte Zufallszahl in der Response RE über den im Zertifikat enthaltenen öffentlichen Schlüssel zu entschlüsseln. Ist das Entschlüsseln erfolgreich, ist der FI-Schutzschalter 3 erfolgreich authentisiert.

Sollte das Entschlüsseln und damit die Authentisierung nicht erfolgreich sein, können entsprechende Gegenmaßnahmen durch die Prüfeinheit 1 ergriffen werden bzw. eine entsprechende Warnung ausgegeben werden, z.B. eine Warnung dahingehend, dass festgestellt wurde, dass in dem Stromnetz eine nicht-authentisierbare Komponente verbaut ist, bei der es sich unter Umständen um ein Plagiat handelt.

In der Ausführungsform der Fig. 3 wird in einem nächsten Schritt S6, der auf eine erfolgreiche Authentisierung gemäß Schritt S5 folgt, der in der Response RE enthaltene Produkt-Identifikationscode verifiziert. Dabei sind in der Prüfeinheit 1 Konfigurationsinformationen hinterlegt, welche spezifizieren, welcher FI-Schalter ursprünglich im Stromnetz verbaut wurde. Stimmt der Produkt-Identifikationscode in der Response RE mit dem Produkt-Identifikationscode gemäß den Konfigurationsdaten überein, sind keine weiteren Maßnahmen von der Prüfeinheit vorzunehmen. Sollten Abweichungen auftreten, können in einem Schritt S7 entsprechende Gegenmaßnahmen eingeleitet werden, insbesondere kann eine Warnmeldung ausgegeben werden bzw. die Sicherheitsfunktionen innerhalb des Stromnetzes verbessert werden, indem beispielsweise der Wert für den maximalen Strom einer Sicherung im Stromnetz herabgesetzt wird. Gegebenenfalls besteht auch die Möglichkeit, das Stromnetz komplett vom Energieversorgungsnetz zu trennen.

Anhand der Fig. 3 wurde eine Identifizierung und Authentisierung einer elektrischen Komponente basierend auf einem asymmetrischen Verfahren mit einem privaten geheimen Schlüssel und mit einem öffentlichen Schlüssel beschrieben. Das Verfahren zur Authentisierung kann jedoch in beliebiger Weise abgewandelt sein, insbesondere kann auch ein symmetrisches Verfahren mit einem einzigen Schlüssel eingesetzt werden. Dieser Schlüssel kann wiederum zum Verschlüsseln einer Challenge CH im Schalter 3 verwendet. Der gleiche Schlüssel wird dabei auch von der Prüfeinheit 1 zum Entschlüsseln eingesetzt, wobei der Schlüssel vorab in der Prüfeinheit hinterlegt sein kann bzw. basierend auf einem Master-Schlüssel in der Prüfeinheit 1 abgeleitet wird. Alternativ kann hier auch ein Challenge Response Verfahren unter Nutzung von kryptographisch basierten Checksummen (HMAC) realisiert werden. Hier fließt der symmetrische Schlüssel auf beiden Seiten in die Berechnung mit ein. Die Ableitung erfolgt dann insbesondere mit Hilfe einer eindeutigen Identifikation des Schalters 3, welche innerhalb der Response RE übertragen wird. Für die Schlüsselableitung kann z.B. ein HMAC-SHA1-Algorithmus verwendet werden, in den der Master-Schlüssel und die eindeutige Identifikation des Schalters als Eingabeparameter eingehen. In einer Variante des erfindungsgemäßen Verfahrens besteht auch die Möglichkeit, dass auf eine vorgeschaltete Authentisierung verzichtet wird und nur übermittelte Identifikationsdaten der elektrischen Komponente geprüft werden. Ebenso besteht die Möglichkeit, dass nur eine Authentisierung durchgeführt wird und keine weiteren Identifikationsdaten in der Form einer Produkt-Identifikation übermittelt werden.

Die im Vorangegangenen beschriebenen Ausführungsformen des erfindungsgemäßen Verfahrens weisen eine Reihe von Vorteilen auf. Es wird die Authentisierung von elektrischen Komponenten in einem Stromnetz, insbesondere von Schaltern und Sicherungen, mittels einer Datenübertragung innerhalb des Stromnetzes ermöglicht. Hierdurch wird die Sicherheit einer elektrischen Anlage erhöht, da fehlerhafte Installationen und nicht zugelassene elektrische Komponenten erkannt werden können. Darüber hinaus kann gegebenenfalls die automatische Erfassung der tatsächlichen Elektroinstallation durch die Identifikation der aufgeschalteten elektrischen Komponenten ermöglicht werden. Ebenso können Veränderungen an der Elektroinstallation festgestellt werden. Ferner können gemäß einem oder mehreren Kriterien entsprechende Schutzmaßnahmen eingeleitet werden, wenn die Elektroinstallation bestimmten Anforderungen nicht genügt, beispielsweise wenn nicht-authentisierbare Komponenten verbaut sind bzw. die Elektroinstallation von einer erwarteten Konfiguration abweicht. Die Schutzmaßnahmen können beliebig ausgestaltet sein. Sie können gegebenenfalls nur darin bestehen, dass ein Warnhinweis an eine Leitstelle bzw. an den Nutzer der Prüfeinheit ausgegeben wird.

Die erfindungsgemäße Prüfung von elektrischen Komponenten kann auf einfache Weise mit an sich bekannten Methoden einer Datenübertragung über das Stromnetz sowie entsprechender kryptographischer Verfahren realisiert werden. Die kryptographischen Funktionen können beispielsweise durch einen entsprechenden Chip durchgeführt werden, der in der Prüfeinheit bzw. den zu prüfenden elektrischen Komponenten verbaut ist. Auf diese Weise wird eine kostengünstige Integration einer Prüffunktionalität in entsprechenden elektrischen Komponenten, wie Sicherungen, FI-Schalter und dergleichen, erreicht.

## Patentansprüche

1. Verfahren zum Prüfen von elektrischen Komponenten (3, 4) in einem Stromnetz, insbesondere in einem Gebäudestromnetz, bei dem
- von einer Prüfeinheit (1) ein Prüfkommando (CH) mittels einer Datenübertragung über das Stromnetz an eine oder mehrere elektrische Komponenten (3, 4) des Stromnetzes gesendet wird;
- eine jeweilige elektrische Komponente (3, 4), welche das an sie gesendete Prüfkommando (CH) empfängt, eine die jeweilige elektrische Komponente (3, 4) charakterisierende Prüfantwort (RE) mittels einer Datenübertragung über das Stromnetz an die Prüfeinheit (1) zurücksendet, woraufhin die zurückgesendete Prüfantwort (RE) in der Prüfeinheit (1) ausgewertet wird;
**dadurch gekennzeichnet, dass** die Auswertung der Prüfantwort (RE) eine Authentisierung der die Prüfantwort (RE) zurücksendenden elektrischen Komponente (3, 4) umfasst, bei der über das von der Prüfeinheit (1) ausgesendete Prüfkommando (CH) und die von der elektrischen Komponente (3, 4) zurückgesendete Prüfantwort (RE) die elektrische Komponente (3, 4) in der Prüfeinheit (1) authentisiert wird.

2. Verfahren nach Anspruch 1, bei dem als elektrische Komponenten (3, 4) eine oder mehrere Sicherungen (4) und/oder Fehlerstrom-Schutzschalter (3) im Stromnetz geprüft werden.

3. Verfahren nach Anspruch 1 oder 2, bei dem zur Durchführung der Authentisierung das Prüfkommando (CH) Verifizierungsdaten enthält, welche von der jeweiligen elektrischen Komponente (3, 4), die das an sie gesendete Prüfkommando (CH) empfängt, kryptographisch gesichert werden, wobei die kryptographisch gesicherten Verifizierungsdaten innerhalb der Prüfantwort (RE) zurückgesendet werden und in der Prüfeinheit (1) die jeweilige elektrische Komponente (3, 4) erfolgreich authentisiert wird, falls die kryptographisch gesicherten Verifizierungsdaten in der Prüfeinheit (1) verifizierbar sind.

4. Verfahren nach Anspruch 3, bei dem die Verifizierungsdaten von der jeweiligen elektrischen Komponente (3, 4) mit einem symmetrischen, in der jeweiligen elektrischen Komponente (3, 4) hinterlegten Schlüssel kryptographisch gesichert werden, wobei zum Verifizieren der kryptographisch gesicherten Verifizierungsdaten der symmetrische Schlüssel auch in der Prüfeinheit (1) hinterlegt ist oder aus einem in der Prüfeinheit (1) hinterlegten Master-Schlüssel unter Einbeziehung von in der Prüfantwort (RE) enthaltenen Identifikationsdaten der elektrischen Komponente (3, 4) abgeleitet wird.

5. Verfahren nach Anspruch 3 oder 4, bei dem die Verifizierungsdaten von der jeweiligen elektrischen Komponente mit einem privaten, in der jeweiligen elektrischen Komponente (3, 4) hinterlegten Schlüssel kryptographisch gesichert werden, wobei zum Verifizieren der kryptographisch gesicherten Verifizierungsdaten ein in der Prüfantwort (RE) enthaltener öffentlicher Schlüssel verwendet wird, falls ein in der Prüfantwort (RE) enthaltenes Zertifikat durch die Prüfeinheit (1) erfolgreich verifiziert wird, oder wobei zum Verifizieren der kryptographisch gesicherten Verifizierungsdaten ein in der Prüfeinheit (1) hinterlegter öffentlicher Schlüssel verwendet wird.

6. Verfahren nach einem der vorhergehenden Ansprüche, bei dem die Prüfantwort (RE) eine oder mehrere Informationen zu der Identität und/oder zu charakteristischen Eigenschaften der jeweiligen elektrischen Komponente (3, 4) enthält.

7. Verfahren nach einem der vorhergehenden Ansprüche, bei dem das Prüfkommando (CH) von der Prüfeinheit (1) an eine oder mehrere vorbestimmte elektrische Komponenten (3, 4) im Stromnetz gesendet wird und/oder als Broadcast-Kommando in das Stromnetz ausgesendet wird.

8. Verfahren nach einem der vorhergehenden Ansprüche, bei dem das Prüfkommando (CH) und die Prüfantwort (RE) basierend auf einer Datenübertragung mittels einer PLC-Kommunikation übermittelt werden.

9. Verfahren nach einem der vorhergehenden Ansprüche, bei dem das Prüfkommando (CH) und die Prüfantwort (RE) basierend auf einer Datenübertragung mittels einer Lastmodulation übermittelt werden, bei der Informationen durch das Aufschalten und/oder Verändern von einem oder mehreren elektrischen Lasten übertragen werden.

10. Verfahren nach einem der vorhergehenden Ansprüche, bei dem das Prüfkommando (CH) und die Prüfantwort (RE) basierend auf einer Datenübertragung mittels einer Phasenanschnitt- und/oder Phasenabschnittsteuerung übermittelt werden, bei der Informationen über eine Verzögerung des Stroms in dem Stromnetz übertragen werden.

11. Verfahren nach einem der vorhergehenden Ansprüche, bei dem das Prüfkommando (CH) und die Prüfantwort (RE) basierend auf einer Datenübertragung mittels eines Trägersignals übermittelt werden, welches durch Frequenzumtastung und/oder Phasenumtastung und/oder Pulsweitenmodulation moduliert ist.

12. Verfahren nach einem der vorhergehenden Ansprüche, wobei bei der Auswertung der zurückgesendeten Prüfantwort (RE) oder Prüfantworten eine oder mehrere der elektrischen Komponenten (3, 4) des Stromnetzes im Hinblick auf die Erfüllung von einem oder mehreren Kriterien überprüft werden, wobei in Abhängigkeit von dem Überprüfungsergebnis eine oder mehrere Aktionen von der Prüfeinheit (1) durchgeführt werden.

13. Verfahren nach Anspruch 12, bei dem das oder die Aktionen eine oder mehrere der folgenden Aktionen umfasst:
- Veränderung der Einstellung von einer oder mehreren der elektrischen Komponenten (3, 4);
- Trennen des Stromnetzes von einer Netzversorgung oder Verhindern des Verbindens des Stromnetzes mit der Netzversorgung;
- Übermitteln von Daten bezüglich der Konfiguration des Stromnetzes an eine Leitstelle;
- Ausgeben einer von einem Benutzer wahrnehmbaren Meldung.

14. Prüfeinheit zur Verwendung in einem Verfahren nach einem der vorhergehenden Ansprüche, wobei die Prüfeinheit (1) derart ausgestaltet ist, dass sie im Betrieb
- ein Prüfkommando (CH) mittels einer Datenübertragung über ein Stromnetz an eine oder mehrere elektrische Komponenten (3, 4) des Stromnetzes sendet;
- eine Prüfantwort (RE) auswertet, welche mittels einer Datenübertragung über das Stromnetz an die Prüfeinheit (1) von einer jeweiligen elektrischen Komponente (3, 4) zurückgesendet wird und welche die jeweilige elektrische Komponente (3, 4) charakterisiert, wobei die Auswertung der Prüfantwort (RE) eine Authentisierung der die Prüfantwort (RE) zurücksendenden elektrischen Komponente (3, 4) umfasst, bei der über das von der Prüfeinheit (1) ausgesendete Prüfkommando (CH) und die von der elektrischen Komponente (3, 4) zurückgesendete Prüfantwort (RE) die elektrische Komponente (3, 4) in der Prüfeinheit (1) authentisiert wird.

15. Prüfeinheit nach Anspruch 15, wobei die Prüfeinheit (1) eine portable Prüfeinheit ist, welche insbesondere mit dem Stromnetz über eine Steckdose verbindbar ist.

16. Prüfeinheit nach Anspruch 14 oder 15, wobei die Prüfeinheit (1) eine fest in dem Stromnetz verbaubare Komponente ist, welche insbesondere in einem Stromzähler und/oder in einem Stromverteiler einbaubar ist.

17. Elektrische Komponente zur Verwendung in einem Verfahren nach einem der Ansprüche 1 bis 13, wobei die elektrische Komponente (3, 4) derart ausgestaltet ist, dass sie bei Betrieb in einem Stromnetz bei Empfang eines Prüfkommandos (CH) einer Prüfeinheit (1) eine Prüfantwort (RE) mittels einer Datenübertragung über das Stromnetz an die Prüfeinheit (1) zurücksendet, wobei die Prüfantwort (RE) die elektrische Komponente (3, 4) charakterisiert und von der Prüfeinheit (1) auswertbar ist, wobei die Prüfantwort (RE) derart ausgestaltet ist, dass deren Auswertung eine Authentisierung der die Prüfantwort (RE) zurücksendenden elektrischen Komponente (3, 4) umfasst, bei der über das von der Prüfeinheit (1) ausgesendete Prüfkommando (CH) und die von der elektrischen Komponente (3, 4) zurückgesendete Prüfantwort (RE) die elektrische Komponente (3, 4) in der Prüfeinheit (1) authentisiert wird.

## Claims

1. Method for testing electrical components (3, 4) in a mains supply, especially in a mains supply of a building, in which
- a check command (CH) is sent from a test unit (1) by means of a data transmission over the mains supply to one or more electrical components (3, 4) of the mains supply;
- a respective electrical component (3, 4), which receives the check command (CH) sent to it, returns a test response (RE) characterising the respective electrical component (3, 4) by means of a data transmission over the mains supply to the test unit (1), after which the returned test response (RE) is evaluated in the test unit (1);
**characterised in that** the evaluation of the test response (RE) comprises an authentication of the electrical component (3, 4) returning the test response (RE), in which the electrical component (3, 4) is authenticated in the test unit (1) by the check command (CH) sent out by the test unit (1) and the test response (RE) returned by the electrical component (3, 4).

2. Method according to claim 1, in which one or more fuses (4) and/or earth leakage circuit breakers (3) in the mains supply are tested as electrical components (3, 4).

3. Method according to claim 1 or 2, in which to carry out the authentication, the check command (CH) contains verification data which is secured cryptographically by the respective electrical component (3, 4), which receives the check command (CH) sent to it, with the cryptographically-secured verification data being returned within the test response (RE) and the respective electrical component (3, 4) being successfully authenticated in the test unit (1) if the cryptographically-secured verification data is able to be verified in the test unit (1).

4. Method according to claim 3, in which the verification data of the respective electrical component (3, 4) is cryptographically secured with a symmetrical key stored in the respective electrical component (3, 4), with the symmetrical key also being stored in the test unit (1) for verification of the cryptographically-secured verification data or being derived from a master key stored in the test unit (1), with the inclusion of identification data of the electrical component (3, 4) contained in the test response (RE).

5. Method according to claim 3 or 4, in which the verification data of the respective electrical component is cryptographically secured with a private key stored in the respective electrical component (3, 4), with a public key contained in the test response (RE) being used to verify the cryptographically-secured verification data if a certificate contained in the test response (RE) is successfully verified by the test unit (1), or with a public key stored in the test unit (1) being used to verify the cryptographically-secured verification data.

6. Method according to one of the preceding claims, in which the test response (RE) contains one or more items of information about the identity and/or about characteristic properties of the respective electrical component (3, 4).

7. Method according to one of the preceding claims, in which the check command (CH) is sent out by the test unit (1) to one or more predetermined electrical components (3, 4) in the mains supply and/or as a broadcast command into the mains supply.

8. Method according to one of the preceding claims, in which the check command (CH) and the test response (RE) are transferred based on a data transmission by means of a PLC communication.

9. Method according to one of the preceding claims, in which the check command (CH) and the test response (RE) are transferred based on a data transmission by means of a load modulation, in which the information is transmitted by connection and/or modification of one or more electrical loads.

10. Method according to one of the preceding claims, in which the check command (CH) and the test response (RE) are transferred based on a data transmission by means of a leadingedge and/or trailing edge phase control, in which information is transmitted by delaying the current in the mains supply.

11. Method according to one of the preceding claims, in which the check command (CH) and the test response (RE) are transferred based on a data transmission by means of a carrier signal which is modulated by frequency shift keying and/or phase shift keying and/or pulse width modulation.

12. Method according to one of the preceding claims, in which, in the evaluation of the returned test response (RE) or test responses, one or more of the electrical components (3, 4) of the mains supply is checked for compliance with one or more criteria, with one or more actions being carried out by the test unit (1) depending on the result of the check.

13. Method according to claim 12, in which the action or actions include one or more of the following actions:
- changing the setting of one or more of the electrical components (3, 4);
- disconnecting the mains supply from a mains network or preventing the mains supply being connected to a mains network;
- transfer of data relating to the configuration of the mains supply to a control centre;
- output of a message able to be perceived by a user.

14. Test unit for use in a method according to one of the preceding claims, with the test unit (1) being embodied such that, when it is operating,
- it sends a check command (CH) by means of a data transmission via a mains supply to one or more electrical components (3, 4) of the mains supply;
- it evaluates a test response (RE) which is returned by means of a data transmission via the mains supply to the test unit (1) by a respective electrical component (3, 4) and which characterises the respective electrical component (3, 4), wherein the evaluation of the test response (RE) comprises an authentication of the electrical component (3, 4) returning the test response (RE), in which the electrical component (3, 4) is authenticated in the test unit (1) by the check command (CH) sent out by the test unit (1) and the test response (RE) returned by the electrical component (3, 4).

15. Test unit according to claim 15, with the test unit (1) being a portable test unit, which in particular is able to be connected to the mains supply via a socket.

16. Test unit according to claim 14 or 15, with the test unit (1) being a component able to be installed permanently in the mains supply, which is especially able to be installed in an electricity meter and/or a consumer unit.

17. Electrical component for use in a method according to one of claims 1 to 13, with the electrical component (3, 4) being embodied such that, when it is operated in a mains supply, on receipt of a check command (CH) of a test unit (1), it returns a test response (RE) to the test unit (1) by means of a data transmission via the mains supply, with the test response (RE) characterising the electrical component (3, 4) and able to be evaluated by the test unit (1), wherein the test response (RE) is embodied such that its evaluation comprises an authentication of the electrical component (3, 4) returning the test response (RE), in which the electrical component (3, 4) is authenticated in the test unit (1) by the check command (CH) sent out by the test unit (1) and the test response (RE) returned by the electrical component (3, 4).

## Revendications

1. Procédé pour contrôler des composants électriques (3, 4) dans un réseau électrique, en particulier dans un réseau électrique d'un bâtiment, dans lequel
- une unité de contrôle (1) envoie une instruction de contrôle (CH) à un ou plusieurs composants électriques (3, 4) du réseau électrique au moyen d'une transmission de données via le réseau électrique ;
- un composant électrique (3, 4) respectif, qui reçoit l'instruction de contrôle (CH) qui lui a été envoyée, renvoie à l'unité de contrôle (1) une réponse de contrôle (RE) caractérisant le composant électrique (3, 4) respectif au moyen d'une transmission de données via le réseau électrique, après quoi la réponse de contrôle (RE) renvoyée est évaluée dans l'unité de contrôle (1) ;
**caractérisé en ce que** l'évaluation de la réponse de contrôle (RE) comprend une authentification du composant électrique (3, 4) renvoyant la réponse de contrôle (RE), lors de laquelle le composant électrique (3, 4) est authentifié dans l'unité de contrôle (1) au moyen de l'instruction de contrôle (CH) envoyée par l'unité de contrôle (1) et de la réponse de contrôle (RE) renvoyée par le composant électrique (3, 4).

2. Procédé selon la revendication 1, dans lequel, comme composants électriques (3, 4), un ou plusieurs fusibles (4) et/ou interrupteurs de protection contre les courants de défaut (3) sont contrôlés dans le réseau électrique.

3. Procédé selon la revendication 1 ou 2, dans lequel, pour effectuer l'authentification, l'instruction de contrôle (CH) contient des données de vérification, lesquelles sont sécurisées cryptographiquement par le composant électrique (3, 4) respectif qui reçoit l'instruction de contrôle (CH) qui lui a été envoyée, les données de vérification sécurisées cryptographiquement étant renvoyées dans la réponse de contrôle (RE) et le composant électrique (3, 4) respectif étant authentifié avec succès dans l'unité de contrôle (1) si les données de vérification sécurisées cryptographiquement sont vérifiables dans l'unité de contrôle (1).

4. Procédé selon la revendication 3, dans lequel les données de vérification sont sécurisées cryptographiquement par le composant électrique (3, 4) respectif au moyen d'une clé symétrique déposée dans le composant électrique (3, 4) respectif, et pour vérifier les données de vérification sécurisées cryptographiquement, la clé symétrique est déposée également dans l'unité de contrôle (1) ou est déduite d'une clé maître déposée dans l'unité de contrôle (1) en y associant des données d'identification du composant électrique (3, 4) contenues dans la réponse de contrôle (RE).

5. Procédé selon la revendication 3 ou 4, dans lequel les données de vérification sont sécurisées cryptographiquement par le composant électrique respectif au moyen d'une clé privée déposée dans le composant électrique (3, 4) respectif, et pour vérifier les données de vérification sécurisées cryptographiquement, une clé publique contenue dans la réponse de contrôle (RE) est utilisée si le certificat contenu dans la réponse de contrôle (RE) est vérifié avec succès par l'unité de contrôle (1), ou pour vérifier les données de vérification sécurisées cryptographiquement, une clé publique déposée dans l'unité de contrôle (1) est utilisée.

6. Procédé selon l'une des revendications précédentes, dans lequel la réponse de contrôle (RE) contient une ou plusieurs informations sur l'identité et/ou sur des propriétés caractéristiques du composant électrique (3, 4) respectif.

7. Procédé selon l'une des revendications précédentes, dans lequel l'instruction de contrôle (CH) est envoyée par l'unité de contrôle (1) à un ou plusieurs composants électriques (3, 4) prédéterminés dans le réseau électrique et/ou est émise comme instruction de diffusion dans le réseau électrique.

8. Procédé selon l'une des revendications précédentes, dans lequel l'instruction de contrôle (CH) et la réponse de contrôle (RE) sont transmises sur la base d'une transmission de données au moyen d'une communication PLC.

9. Procédé selon l'une des revendications précédentes, dans lequel l'instruction de contrôle (CH) et la réponse de contrôle (RE) sont transmises sur la base d'une transmission de données au moyen d'une modulation de charge consistant à transmettre des informations en connectant et/ou en modifiant une ou plusieurs charges électriques.

10. Procédé selon l'une des revendications précédentes, dans lequel l'instruction de contrôle (CH) et la réponse de contrôle (RE) sont transmises sur la base d'une transmission de données au moyen d'une commande à coupure de phase ascendante et/ou à coupure de phase descendante consistant à transmettre des informations via un retardement du courant dans le réseau électrique.

11. Procédé selon l'une des revendications précédentes, dans lequel l'instruction de contrôle (CH) et la réponse de contrôle (RE) sont transmises sur la base d'une transmission de données au moyen d'un signal porteur ayant fait l'objet d'une modulation par déplacement de fréquence et/ou déplacement de phase et/ou d'une modulation d'impulsions en largeur.

12. Procédé selon l'une des revendications précédentes, dans lequel, lors de l'évaluation de la ou des réponses de contrôle (RE) renvoyées, un ou plusieurs des composants électriques (3, 4) du réseau électrique sont contrôlés quant au respect d'un ou de plusieurs critères, et en fonction du résultat de contrôle une ou plusieurs actions sont mises en oeuvre par l'unité de contrôle (1).

13. Procédé selon la revendication 12, dans lequel la ou les actions comprennent une ou plusieurs des actions suivantes :
- modifier le réglage d'un ou plusieurs des composants électriques (3, 4) ;
- déconnecter le réseau électrique d'une alimentation réseau ou empêcher la connexion du réseau électrique à l'alimentation réseau ;
- communiquer des données concernant la configuration du réseau électrique à un poste de commande ;
- délivrer un message perceptible par un utilisateur.

14. Unité de contrôle destinée à être utilisée dans un procédé selon l'une des revendications précédentes, l'unité de contrôle (1) étant configurée de telle sorte que, en fonctionnement,
- elle envoie une instruction de contrôle (CH) à un ou plusieurs composants électriques (3, 4) du réseau électrique au moyen d'une transmission de données via le réseau électrique ;
- elle évalue une réponse de contrôle (RE) qui est renvoyée à l'unité de contrôle (1) par un composant électrique (3, 4) respectif au moyen d'une transmission de données via le réseau électrique et qui caractérise le composant électrique (3, 4) respectif, l'évaluation de la réponse de contrôle (RE) comprenant une authentification du composant électrique (3, 4) renvoyant la réponse de contrôle (RE), lors de laquelle le composant électrique (3, 4) est authentifié dans l'unité de contrôle (1) au moyen de l'instruction de contrôle (CH) envoyée par l'unité de contrôle (1) et de la réponse de contrôle (RE) renvoyée par le composant électrique (3, 4).

15. Unité de contrôle selon la revendication 15, l'unité de contrôle (1) étant une unité de contrôle portable qui peut notamment être reliée au réseau électrique par une prise.

16. Unité de contrôle selon la revendication 14 ou 15, l'unité de contrôle (1) étant un composant qui peut être installé de manière fixe dans le réseau électrique et qui peut notamment être monté dans un compteur électrique et/ou dans un répartiteur de courant.

17. Composant électrique destiné à être utilisé dans un procédé selon l'une des revendications 1 à 13, le composant électrique (3, 4) étant configuré de telle sorte que, lorsqu'il fonctionne dans un réseau électrique, et qu'il reçoit une instruction de contrôle (CH) d'une unité de contrôle (1), il renvoie à l'unité de contrôle (1) une réponse de contrôle (RE) au moyen d'une transmission de données via le réseau électrique, laquelle réponse de contrôle (RE) caractérise le composant électrique (3, 4) et peut être évaluée par l'unité de contrôle (1), la réponse de contrôle (RE) étant telle que son évaluation comprend une authentification du composant électrique (3, 4) renvoyant la réponse de contrôle (RE), lors de laquelle le composant électrique (3, 4) est authentifié dans l'unité de contrôle (1) au moyen de l'instruction de contrôle (CH) envoyée par l'unité de contrôle (1) et de la réponse de contrôle (RE) renvoyée par le composant électrique (3, 4).
